(19) Europäisches Patentamt / European Patent Office / Office européen des brevets

(11) **EP 2 913 910 B1**

(12) **FASCICULE DE BREVET EUROPEEN**

(45) Date de publication et mention
de la délivrance du brevet:
**10.08.2022   Bulletin 2022/32**

(21) Numéro de dépôt: **15156084.4**

(22) Date de dépôt: **23.02.2015**

(51) Classification Internationale des Brevets (IPC):
*H02K 11/33* (2016.01)   *H02K 11/02* (2016.01)
*H02K 5/18* (2006.01)   *H02K 5/20* (2006.01)
*H02K 9/06* (2006.01)   *H02K 11/04* (2016.01)
*H05K 7/20* (2006.01)

(52) Classification Coopérative des Brevets (CPC):
**H05K 7/20909; H02K 5/18; H02K 5/207;
H02K 11/02; H02K 11/33;** H02K 9/06; H02K 11/05

(54) **Machine électrique tournante pour véhicule automobile comprenant un ensemble électronique**

Rotierende elektrische Maschine für ein Kraftfahrzeug umfassend eine Elektronikeinheit

Rotary electric machine for a motor vehicle comprising an electronic assembly

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **26.02.2014   FR 1451518**

(43) Date de publication de la demande:
**02.09.2015   Bulletin 2015/36**

(73) Titulaire: **VALEO EQUIPEMENTS ELECTRIQUES
MOTEUR
94046 Créteil Cedex (FR)**

(72) Inventeurs:
• **Falguier, Manuel**
**94500 CHAMPIGNY SUR MARNE (FR)**
• **Fakes, Michel**
**59113 SECLIN (FR)**
• **Guerin, Fabien**
**92320 CHATILLON (FR)**
• **Le-Meitour, Yannick**
**92290 Châtenay Malabry (FR)**
• **Hosni, Alexis**
**75018 PARIS (FR)**

(74) Mandataire: **Valeo Powertrain Systems
Service Propriété Intellectuelle
Immeuble le Delta
14, avenue des Béguines
95892 Cergy Pontoise (FR)**

(56) Documents cités:
EP-A1- 2 557 676          WO-A1-2009/063774
DE-A1-102008 007 825    DE-A1-102010 044 439
FR-A1- 2 827 437          FR-A1- 2 847 085
FR-A1- 2 923 098          US-A1- 2008 204 998
US-A1- 2013 027 887

EP 2 913 910 B1

**Description**

DOMAINE TECHNIQUE DE L'INVENTION

La présente invention concerne une machine électrique tournante pour véhicule automobile, la machine électrique tournante comportant un ensemble électronique.

Elle trouve une application particulière mais non limitative dans le domaine des alterno-démarreurs de véhicule automobile, par exemple pour des alterno-démarreurs ou moteur-générateurs adaptés pour des applications véhicule de type « mild-hybrid ».

ARRIÈRE-PLAN TECHNOLOGIQUE DE L'INVENTION

Dans un véhicule automobile comportant un moteur thermique et une machine électrique tournante telle qu'un alterno-démarreur, un telle machine comporte de manière non limitative :

- un rotor comprenant un inducteur dans lequel est amené un courant d'excitation ; et
- un stator comprenant un bobinage polyphasé.

L'alterno-démarreur fonctionne en mode moteur ou en mode générateur. C'est une machine dite réversible.

En mode alternateur appelé également mode générateur, la machine permet de transformer un mouvement de rotation du rotor entraîné par le moteur thermique du véhicule, en un courant électrique induit dans les phases du stator. Dans ce cas, un pont redresseur relié aux phases du stator permet de redresser le courant induit sinusoïdal en un courant continu pour alimenter des consommateurs du véhicule ainsi qu'une batterie.

Au contraire, en mode moteur, la machine électrique fait office de moteur électrique permettant d'entraîner en rotation, via l'arbre du rotor, le moteur thermique du véhicule. Il permet de transformer l'énergie électrique en énergie mécanique. Dans ce cas un onduleur permet de transformer un courant continu provenant de la batterie en un courant alternatif pour alimenter les phases du stator pour faire tourner le rotor.

Des composants de contrôle sont utilisés pour déterminer le mode de fonctionnement de la machine électrique tournante (mode moteur ou mode générateur) via des signaux de contrôle.

Les alterno-démarreurs qui intègrent une fonction de freinage récupératif et une fonction d'assistance du moteur thermique à l'accélération, appelés en anglais « mild-hybrid », intègrent en outre des composants de filtrage qui empêchent les composants de puissance de perturber le réseau électrique du véhicule automobile, en général un réseau de 48 Volts. Ces machines réversibles ont des puissances de l'ordre de 8 à 15kW.

Les composants de puissance (pont redresseur et onduleur), les composants de contrôle ainsi que les composants de filtrage génèrent de la chaleur. Il est ainsi nécessaire d'utiliser un dispositif de refroidissement pour dissiper cette chaleur émise par tous ces composants.

Dans le document WO 2009/063774, il est décrit une machine électrique tournante pour véhicule automobile selon le préambule de la revendication 1.

Dans le brevet FR2847085, il est décrit un ensemble électronique comprenant les composants de puissance et les composants de contrôle (appelés unités de commande), les deux ensembles de composants étant placés au plus près l'un de l'autre, et un dispositif de refroidissement pour refroidir cet ensemble. Le dispositif de refroidissement comprend :

- un dissipateur sur lequel sont montés les composants de puissance et de contrôle, le dissipateur étant disposé sur le palier arrière de la machine électrique et comprenant des ailettes situées sur sa face inférieure qui se trouve en vis-à-vis du palier. Il existe par ailleurs entre l'arbre de rotation du rotor et le dissipateur, un espace libre par lequel l'air peut circuler ;
- le palier arrière comprenant des ouïes radiales de sortie de l'air ; et
- un capot de protection comprenant des ouvertures situées sur le dessus dudit capot.

Ainsi, d'une part de l'air est aspiré latéralement dans l'alterno-démarreur et s'écoule vers les ouïes radiales de sortie du palier tout en léchant les ailettes du dissipateur, et d'autre part de l'air est aspiré par les ouvertures du capot puis s'écoule axialement le long de l'arbre de rotation (via l'espace libre) du rotor pour rejoindre un passage d'écoulement sous le dissipateur. Ainsi, l'ensemble des composants de puissance et de contrôle est refroidi.

Un inconvénient de cet état de la technique réside dans le fait que le refroidissement n'est pas optimisé par rapport aux besoins de dissipation propres des composants de puissance et de contrôle.

Dans ce contexte, la présente demanderesse a déposé une demande de brevet français n°1358616 portant sur un ensemble électronique comportant un bloc de puissance, un bloc de filtrage, un bloc de contrôle et un capot de protection comportant :

- un premier ensemble d'ouvertures positionné en regard d'un premier élément de refroidissement couplé au bloc de puissance,
- un deuxième ensemble d'ouvertures positionné en regard du bloc de contrôle ;
- un muret de séparation entre les deux ensembles d'ouvertures de sorte à créer un premier flux d'air de refroidissement pour le bloc de puissance, et un deuxième flux d'air de refroidissement pour le bloc de contrôle.

Dans ce contexte, la présente invention vise à résoudre l'inconvénient précédemment mentionné et à présenter une alternative à la demande déposée par la demanderesse.

## DESCRIPTION GENERALE DE L'INVENTION

A cette fin l'invention propose une machine électrique tournante pour véhicule automobile selon la revendication 1.

Ainsi, l'ensemble électronique comprend une architecture et un dispositif de refroidissement qui permet de réaliser un refroidissement adapté aux besoins de dissipation thermique de chaque bloc de composants (puissance, contrôle, filtrage) grâce à la création de flux d'air spécifique pour refroidir chaque bloc, et ce sans avoir à réaliser de muret de séparation ni deux séries d'ouvertures dans le capot de protection pour créer les deux flux d'air radiaux.

Selon des modes de réalisation non limitatifs, l'ensemble électronique, peut comporter en outre une ou plusieurs caractéristiques supplémentaires parmi les suivantes.

- l'ensemble électronique comprend un bloc de filtrage, ledit capot étant adapté pour recouvrir le bloc de filtrage ;
- le dispositif de refroidissement comporte en outre un deuxième élément de refroidissement qui est un deuxième dissipateur couplé à des condensateurs dudit bloc de filtrage;
- le bloc de puissance et le bloc de filtrage sont reliés électriquement au moyen d'une pièce conductrice, notamment de polarité négative ;
- le premier dissipateur et le deuxième dissipateur comportent respectivement des orifices de montage adaptés pour coopérer entre eux ;
- l'assemblage entre le bloc de puissance et le bloc de filtrage fait appel à une vis de montage, ladite pièce conductrice, un isolant thermique disposé entre une patte de montage du premier dissipateur et une face inférieure de ladite pièce conductrice, un premier isolant électrique disposé entre ladite pièce conductrice et un palier arrière de la machine électrique tournante, et un second isolant électrique disposé entre une tête de la vis de montage et une face supérieure d'une patte de montage du deuxième dissipateur ;
- le capot de protection comporte en outre un troisième ensemble d'ouvertures situées sur le dessus dudit capot adapté pour être positionné au dessus de condensateurs du bloc de filtrage de sorte à créer un quatrième flux d'air de refroidissement axial pour le bloc de filtrage ;
- le dispositif de refroidissement comporte en outre un troisième élément de refroidissement qui est un troisième dissipateur couplé au bloc de contrôle ;
- le troisième dissipateur est couplé à des composants du bloc de contrôle au moyen d'une résine, d'une lame métallique, d'un joint de remplissage ou d'un tampon de remplissage ;
- le deuxième dissipateur et/ou le troisième dissipateur sont munis d'une pluralité d'ailettes ;
- les ailettes du premier dissipateur sont disposées par groupes d'ailettes parallèles et les groupes sont disposés de manière à autoriser une circulation radiale d'un flux d'air de refroidissement sous le bloc de puissance ;
- les ouvertures du deuxième ensemble d'ouvertures sont respectivement adaptées pour être positionnées en regard des ailettes du deuxième élément de refroidissement.

Selon un mode de réalisation non limitatif, le dispositif de refroidissement comporte en outre un deuxième élément de refroidissement qui est un deuxième dissipateur muni d'une pluralité d'ailettes couplé à des condensateurs dudit bloc de filtrage.

Selon un mode de réalisation non limitatif, le capot de protection comporte en outre un deuxième ensemble d'ouvertures adaptées pour être positionnées en regard des ailettes du deuxième dissipateur de sorte à créer un troisième flux d'air de refroidissement radial pour ledit bloc de filtrage.

Selon un mode de réalisation non limitatif, les ailettes du premier dissipateur sont disposées par groupe d'ailettes parallèles et les groupes sont disposés de manière à autoriser une circulation radiale d'un flux d'air de refroidissement sous le bloc de puissance.

Selon un mode de réalisation non limitatif, le bloc de puissance et le bloc de filtrage sont reliés électriquement au moyen d'une pièce conductrice de polarité négative.

Selon un mode de réalisation non limitatif, le premier dissipateur et le deuxième dissipateur comportent respectivement des orifices de montage adaptés pour coopérer entre eux.

Selon un mode de réalisation non limitatif, l'assemblage entre le bloc de puissance et le bloc de filtrage fait appel à une vis de montage, la pièce conductrice, un isolant thermique disposé entre une patte de montage du premier dissipateur et une face inférieure de ladite pièce conductrice, un premier isolant électrique disposé entre ladite pièce conductrice et un palier arrière de la machine électrique tournante, et un second isolant électrique disposé entre une tête de la vis de montage et une face supérieure d'une patte de montage du deuxième dissipateur.

Selon un mode de réalisation non limitatif, le dispositif de refroidissement comporte en outre un troisième élément de refroidissement qui est un troisième dissipateur muni d'une pluralité d'ailettes couplé au bloc de contrôle.

Selon un mode de réalisation non limitatif, le troisième dissipateur est couplé à des composants du bloc de contrôle au moyen d'une résine, d'une lame métallique, d'un joint de remplissage ou d'un tampon de remplissage.

Selon un mode de réalisation non limitatif, le capot de protection comporte en outre un troisième ensemble d'ouvertures situées sur le dessus dudit capot adapté pour être positionné au dessus des condensateurs du bloc de filtrage de sorte à créer un quatrième flux d'air de refroidissement axial pour le bloc de filtrage.

BREVE DESCRIPTION DES FIGURES

L'invention et ses différentes applications seront mieux comprises à la lecture de la description qui suit et à l'examen des figures qui l'accompagnent.

- la figure 1 représente une vue schématique d'un ensemble électronique pour machine électrique tournante pour véhicule automobile selon l'invention ;
- la figure 2a représente une vue en perspective d'un module de puissance d'un bloc de puissance de l'ensemble électronique de la figure 1 ;
- la figure 2b représente une vue en perspective d'un module d'excitation d'un bloc de puissance de l'ensemble électronique de la figure 1 ;
- la figure 3a représente une vue en perspective d'un bloc de filtrage de l'ensemble électronique de la figure 1 ;
- la figure 3b représente une vue de dessous du bloc de filtrage de la figure 3a ;
- la figure 4 représente un mode de réalisation non limitatif d'assemblage du bloc de filtrage des figures 3a et 3b avec un premier dissipateur de puissance, sans les condensateurs ;
- La figure 5 représente un zoom sur une partie de l'assemblage de la figure 4 avec des éléments d'assemblage ;
- la figure 6 représente une vue en perspective d'un bloc de contrôle de l'ensemble électronique de la figure 1 ;
- la figure 7 représente une vue de dessous du bloc de contrôle de la figure 6 ;
- la figure 8 représente une vue en perspective d'un capot de protection de l'ensemble électronique de la figure 1 ;
- la figure 9a est un schéma explicatif des flux d'air générés par des ouvertures latérales du capot de protection de la figure 8 couplées avec un premier dissipateur selon un premier mode de réalisation non limitatif ;

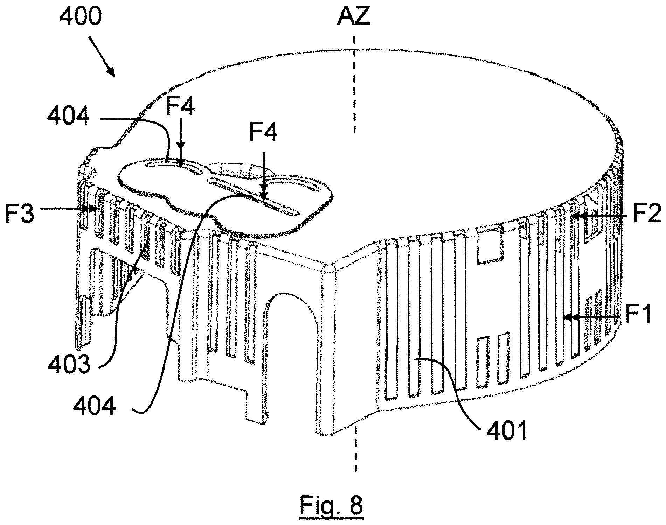

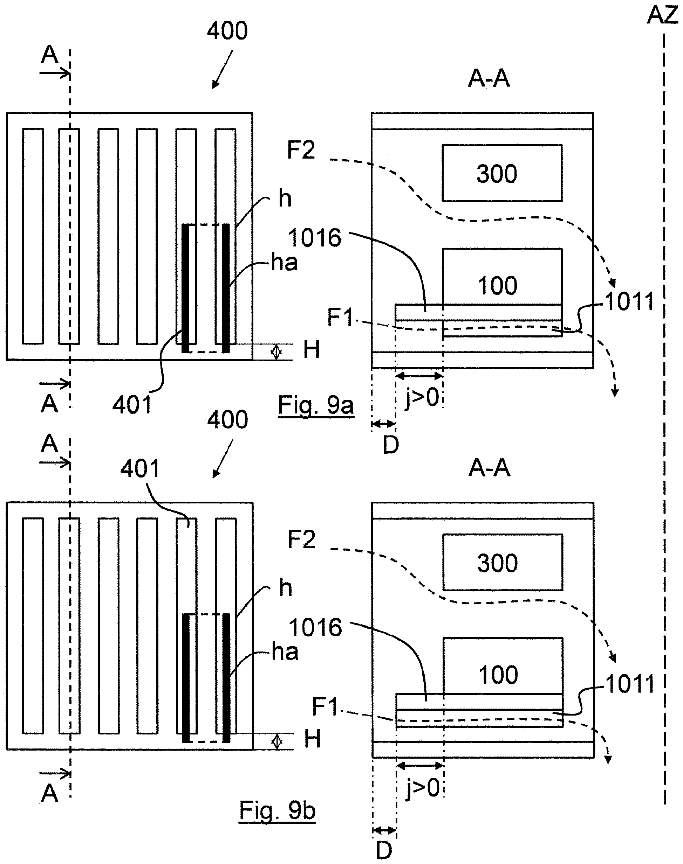

- la figure 9a est un schéma explicatif des flux d'air générés par des ouvertures latérales du capot de protection de la figure 8 couplées avec un premier dissipateur selon un deuxième mode de réalisation non limitatif ;

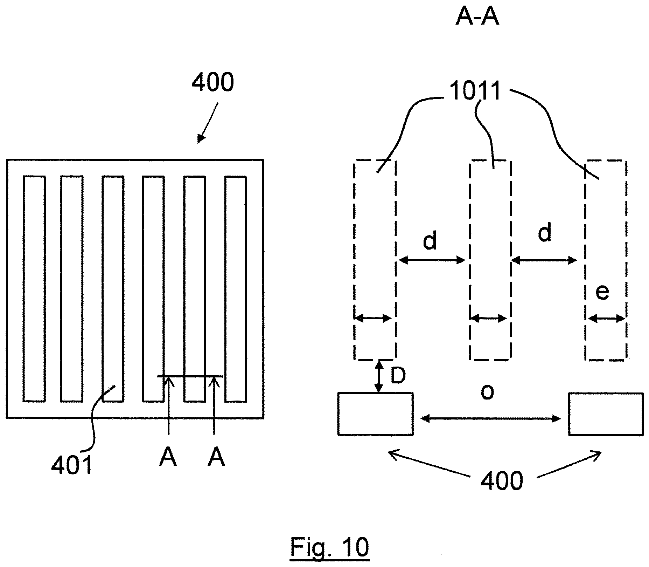

- la figure 10 est un schéma explicatif des ouvertures du capot de protection de la figure 9a ou de la figure 9b qui sont disposées en regard des ailettes d'un premier dissipateur.

DESCRIPTION DE MODES DE REALISATION DE L'INVENTION

Les éléments identiques, par structure ou par fonction, apparaissant sur différentes figures conservent, sauf précision contraire, les mêmes références.

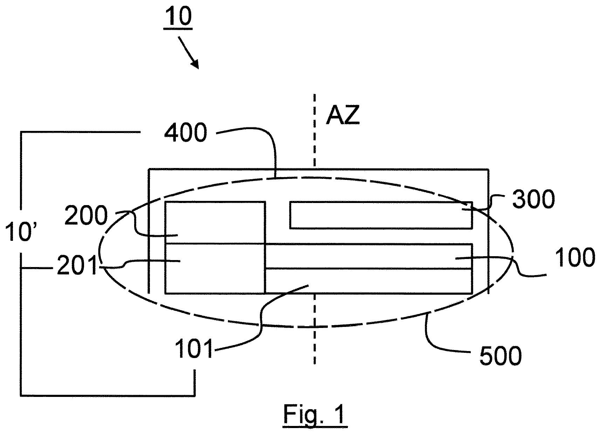

L'ensemble électronique 10 pour machine électrique tournante est décrit en référence aux figures 1 à 10.

La machine électrique tournante est dans un exemple non limitatif un alterno-démarreur pour une application véhicule de type « mild-hybrid ». La machine électrique tournante est dans ce type d'application utilisée non seulement pour la génération électrique et le démarrage du moteur thermique (avec la fonctionnalité dite « Stop & Go » ou « Stop/Start » en anglais), mais également pour le freinage récupératif, la traction à faible vitesse du véhicule et l'assistance en couple du moteur thermique.

Tel qu'illustré schématiquement à la figure 1, selon un mode de réalisation non limitatif, l'ensemble électronique 10 comporte :

- des blocs 100, 200, 300 de composants électroniques, les blocs ayant des besoins de dissipation thermique différents, les blocs étant :

  - un bloc de puissance 100 ;

- un bloc de filtrage 200 ;
- un bloc de contrôle 300 ;

- un dispositif de refroidissement 10' desdits blocs 100, 200, 300, ledit dispositif de refroidissement 10' comportant :

- un capot de protection 400 adapté pour recouvrir les blocs de puissance, de filtrage et de contrôle 100, 200, 300, ledit capot de protection comportant un premier ensemble d'ouvertures 401 adaptées pour être positionnées en regard des ailettes d'un premier élément de refroidissement 101 couplé au bloc de puissance 100, et en regard du bloc de contrôle 300 ; et
- le premier élément de refroidissement 101 qui est un premier dissipateur 101 muni d'une semelle 1016 et d'une pluralité d'ailettes 1011, ladite semelle 1016 faisant saillie par rapport au bloc de puissance 100 de sorte à créer un premier flux d'air de refroidissement radial F1 pour ledit bloc de puissance 100 et un deuxième flux d'air de refroidissement radial F2 pour ledit bloc de contrôle 300.

On entend par semelle 1016 qui fait saillie par rapport au bloc de puissance 100, une semelle qui comporte un prolongement j par rapport audit bloc 100, le prolongement j étant supérieur à zéro.

Comme on va le voir en détail ci-après, grâce à l'architecture de l'ensemble électronique en blocs séparés, à l'architecture de la semelle du premier dissipateur qui permet la création des flux d'air différents pour refroidir les différents blocs, et au couplage entre les éléments de refroidissement aux ouvertures du capot (les éléments de refroidissement coopèrent thermiquement avec les ouvertures du capot), on obtient un découplage thermique entre les différents blocs et on optimise le refroidissement de chaque bloc. On a un refroidissement ciblé pour chaque bloc, chaque bloc ayant des températures de fonctionnement différentes et ayant ainsi des besoins de dissipation thermique différents. On obtient ainsi un meilleur refroidissement de l'ensemble électronique.

Les différents éléments de l'ensemble électronique de puissance et de son dispositif de refroidissement 10', ainsi que les différents flux d'air générés, sont décrits plus en détail ci-après.

Bloc de puissance

Dans cet exemple non limitatif, le bloc de puissance 100 comprend trois modules de puissance 1001 et un module d'excitation 1002.

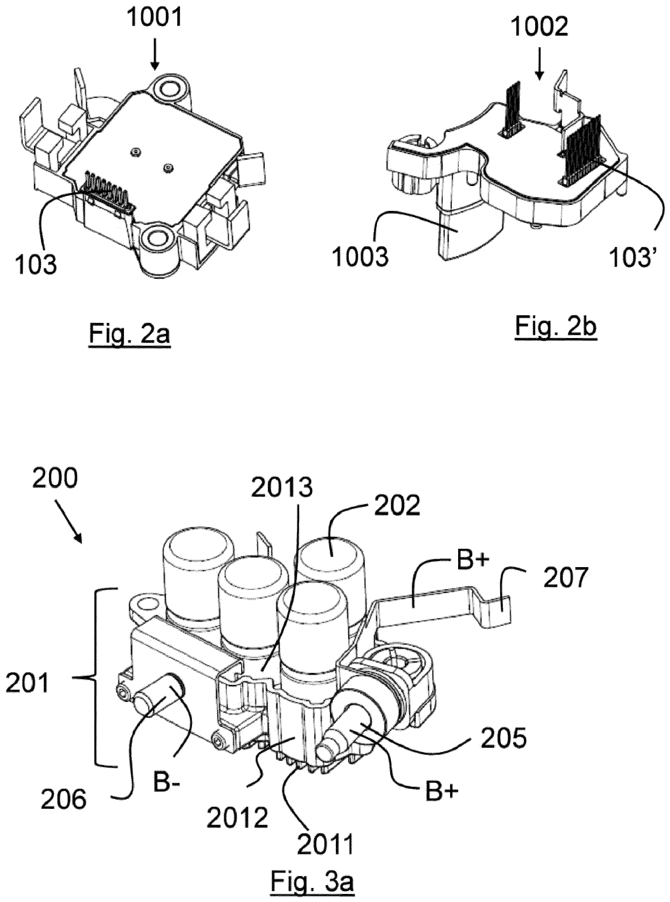

Les modules de puissance 1001, tel qu'illustré dans un mode de réalisation non limitatif sur la figure 2a, comprennent des interrupteurs électroniques, tels que dans un exemple non limitatif des transistors MOSFET, les interrupteurs d'un module étant destinés à réaliser un bras de pont redresseur/onduleur pour une phase de la machine électrique tournante. Le module d'excitation 1002, tel qu'illustré dans un mode de réalisation non limitatif sur la figure 2b, permet d'alimenter la bobine du rotor de ladite machine, ledit module comprenant de manière classique, des transistors MOSFET et des diodes permettant de déterminer le courant dans le rotor. Les modules de puissance 1001 et le module d'excitation 1002 étant des sources de chaleur, il est nécessaire de les refroidir.

A cet effet, le dispositif de refroidissement 10' comprend un premier élément de refroidissement qui est un premier dissipateur 101 (appelé également dissipateur de bloc de puissance) muni d'une pluralité d'ailettes couplé au bloc de puissance 100. Ces dernières sont dans un mode de réalisation non limitatif, disposées de manière sensiblement parallèle sous le bloc de puissance 100. Elles sont typiquement en aluminium.

Ces ailettes vont permettre d'avoir une grande surface d'échange avec l'air qui traverse l'électronique.

Ainsi, comme on le verra par la suite, le refroidissement du bloc 100 sera optimisé grâce aux ailettes du dissipateur 101.

Outre les modules de puissance 1001 et d'excitation 1002, le bloc de puissance 100 comporte des traces conductrices qui permettent le passage de courant dans les composants. Ces traces conductrices sont également des sources de chaleur qu'il est nécessaire de refroidir.

On notera que le premier dissipateur 101 comporte en outre :

- une pluralité de plots de montage, lesdits plots permettant de fixer le bloc de contrôle 300. Ces plots de montage servent d'entretoises entre les deux blocs 100 et 300. Le bloc de contrôle 300 est ainsi disposé sur un plan parallèle à celui du bloc de puissance 100. Dans un exemple non limitatif, quatre plots sont utilisés.
- au moins deux pattes de montage munies d'orifices, ces pattes permettant de fixer le bloc de filtrage 200. Dans un exemple non limitatif, deux pattes de montage sont utilisés. Le bloc de filtrage est décrit ci-après.
- une pluralité d'orifices de montage, lesdits orifices permettant de fixer le bloc de puissance 100. Dans un exemple non limitatif, quatre orifices sont utilisés.

Bloc de filtrage

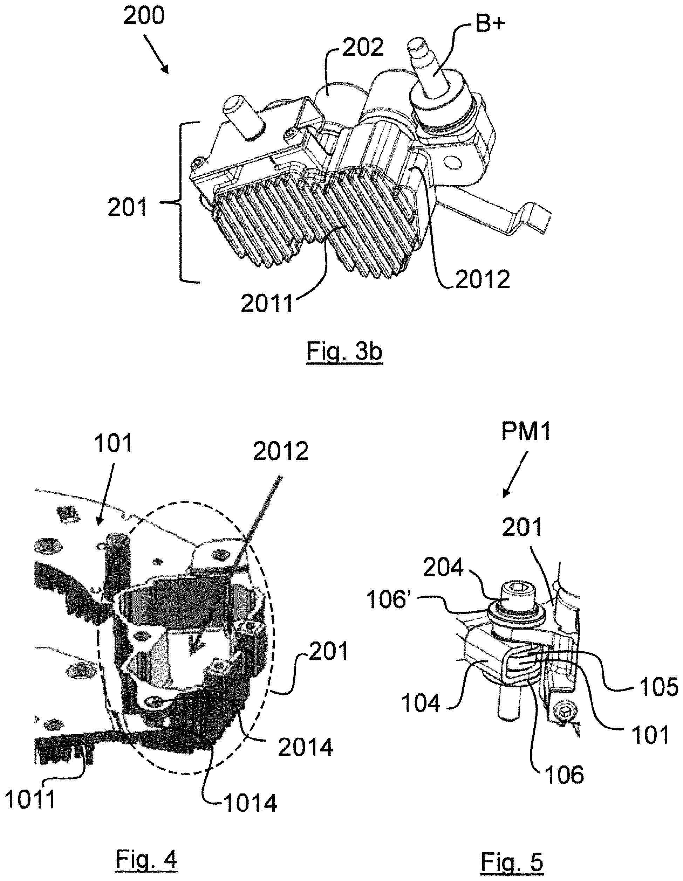

Le bloc de filtrage 200 est illustré sur les figures 3a et 3b.

Comme illustré, le bloc de filtrage 200 comporte une pluralité de condensateurs 202 destinées à filtrer les perturbations provenant des composants de puissance (modules de puissance 1001 notamment).

Afin de refroidir les condensateurs 202, le dispositif de refroidissement 10' comprend un deuxième élément de refroidissement qui est un deuxième dissipateur 201 (appelé également dissipateur de bloc de filtrage) muni d'une pluralité d'ailettes 2011, ledit dissipateur étant couplé aux condensateurs 202.

Ces ailettes vont permettre d'avoir une grande surface d'échange avec l'air qui traverse l'électronique.

Ainsi, comme on le verra par la suite, le refroidissement du bloc 200 et donc des condensateurs 202 sera optimisé grâce aux ailettes du dissipateur 201. On notera que le deuxième dissipateur 201 comporte un logement 2012 (illustré à la figure 4) dans lequel viennent se loger les condensateurs 202. Dans un mode de réalisation non limitatif, le deuxième dissipateur 201 est couplé aux condensateurs 202 du bloc de filtrage 200 au moyen d'une résine 2013. Ainsi, la résine permet non seulement de maintenir lesdits condensateurs 202 dans le dissipateur mais également d'avoir une bonne évacuation des calories des condensateurs vers ledit dissipateur 201.

Dans ce mode de réalisation dans lequel la machine est une machine de type alterno-démarreur fonctionnant sous une tension continue de 48 Volts, des potentiels de tension B+ et B- sont présents dans la machine et correspondent respectivement au +48 V et au 0 V du 48 Volts. On notera ici que le B- (0 V) et le potentiel général de masse M- du véhicule sont isolés électriquement dans la machine, masse générale qui est classiquement reliée à la borne électrique négative de la ou les batteries du véhicule ainsi qu'à la carrosserie de celui-ci et qui est également reliée dans la machine au palier arrière de celle-ci sur lequel est fixé l'ensemble électronique 10. Il est donc prévu une isolation électrique entre l'ensemble électronique dont la masse électrique est au B- et le palier arrière relié au M-. Bien entendu, une connexion électrique peut être effectuée entre B- et M- dans le circuit électrique du véhicule, mais dans cette forme de réalisation celle-ci n'est pas faite dans la machine.

En référence à la figure 3a ou 3b, le B+ est relié au circuit électrique du véhicule à travers une borne électrique 205 isolée du B-. Le B- est relié au circuit électrique du véhicule à travers une borne électrique 206 en liaison électrique avec les masses métalliques (dissipateurs notamment) du bloc de puissance 100 et du bloc de filtrage 200 et la masse du bloc de contrôle 300. Une languette de connexion électrique 207 est également montrée aux figures 3a et 3b, cette languette 207 assure l'interconnexion du B+ entre le bloc de filtrage 200 et le bloc de puissance 100.

Le bloc de puissance 100 et le bloc de filtrage 200 comportent donc tout deux des traces conductrices de polarité positives et négatives reliées respectivement aux potentiels B+ et B-. Ces traces conductrices permettent le passage du courant à travers les composants électroniques des différents blocs 100, 200.

Au niveau du bloc de puissance 100, le premier dissipateur 101 est relié à la masse B-.

Comme on va le voir ci-après, grâce à la combinaison 500 (ou encore groupe ou sous-ensemble), montrée à la figure 1, entre deux blocs de composants électroniques ayant des besoins de dissipation thermique différents, lesdits blocs étant le bloc de puissance 100 et le bloc de filtrage 200, et avec l'aide notamment de moyens d'isolation thermique et électrique et d'une unique pièce conductrice, on obtient à la fois une connexion électrique du B- entre le bloc de puissance 100 et le bloc de filtrage 200 et une isolation électrique de ce B- par rapport au M- du palier arrière, ainsi qu'une forte résistance thermique qui permet d'avoir un bon découplage thermique entre le bloc de puissance 100 et le bloc de filtrage 200.

La combinaison 500 (ou encore groupe ou sous-ensemble) est illustrée à la figure 1 et les liaisons électrique, thermique et mécanique d'une telle combinaison 500 aux figures 4 et 5 notamment. Dans ces dernières figures, le bloc de puissance 100 n'a pas été représenté pour plus de clarté.

Ainsi, dans un mode de réalisation non limitatif, l'assemblage électrique, thermique et mécanique de la combinaison 500, entre les blocs 100 et 200, et le montage de celle-ci au palier arrière de la machine est assuré au niveau de deux points de montage. En un premier point de montage PM1 montré à la figure 5, cet assemblage est réalisé au moyen de :

- une vis de montage 204 ;

- une pièce électriquement conductrice 104 au potentiel B- et dont une première extrémité 1040 est en contact direct, par une face supérieure, avec une patte de montage du bloc de filtrage 200, sur une face inférieure de ladite patte du bloc 200, et une seconde extrémité 1041 est en contact direct, par une face supérieure, avec une patte de montage du bloc de puissance 100, sur une face inférieure de ladite patte du bloc 100, lesdites pattes de bloc 200 et de bloc 100 étant formées par des prolongements des dissipateurs 201 et 101, respectivement ;

- un isolant thermique 105 disposé entre :

  - ladite patte du bloc 100 qui est un prolongement du premier élément de refroidissement 101 qui est le premier dissipateur 101 muni d'une pluralité d'ailettes 1011 couplé audit bloc de puissance 100 ; et

- une face inférieure de ladite pièce conductrice 104 ;

- un premier isolant électrique 106 disposé entre ladite pièce conductrice 104 et le palier arrière de la machine électrique tournante ; et

- un second isolant électrique 106' disposé entre une tête de la vis de montage 204 et une face supérieure de ladite patte du bloc de filtrage 200.

Les fonctions de la pièce conductrice 104, de l'isolant thermique 105 et des isolants électriques 106 et 106' sont expliqués ci-dessous.

Afin de relier au même potentiel B- le bloc de puissance 100 et le bloc de filtrage 200, dans un premier mode de réalisation non limitatif, la pièce conductrice 104 est utilisée tel qu'illustré sur la figure 5. Dans un mode de réalisation non limitatif, ladite pièce conductrice est un bus barre ayant une forme générale en U.

On rappellera qu'un bus barre est une plaque formée de cuivre ou d'aluminium. Dans un mode de réalisation non limitatif, il peut comporter un étamage complémentaire de sorte à empêcher l'oxydation du cuivre.

Ce bus barre 104 est disposé entre le dissipateur de bloc de puissance 101 et le dissipateur de bloc de filtrage 201 tel qu'illustré sur la figure 5, de sorte à créer une jonction entre les deux blocs 101 et 201. Il a ainsi une fonction de conducteur électrique et a une polarité négative B- de par son contact direct avec les pattes des bocs 100 et 200.

Tel qu'illustré sur la figure 4, le premier dissipateur 101 et le deuxième dissipateur 201 comportent respectivement des pattes de montage munies d'orifices de montage 1014, 2014 adaptés pour coopérer entre eux. Comme illustré sur la figure 4, le deuxième dissipateur 201 comportent des orifices de montage 2014 qui se placent en regard des orifices de montage 1014 du premier dissipateur 101 décrits précédemment et les vis de montage 204 s'insèrent dans ces orifices de montage 1014, 2014 et se visent sur le palier arrière, assurant ainsi une fixation mécanique de l'ensemble électronique 10 sur le palier arrière de la machine.

Ce mode de réalisation faisant appel au bus barre 104 et à l'isolant thermique 105 permet de minimiser les échanges thermiques par rapport à un autre mode dans lequel on mettrait les deux dissipateurs 101 et 201 en contact direct par leurs masses métalliques conductrices. En effet, dans le mode de réalisation décrit, la masse conductrice métallique du bus barre est dimensionnée pour obtenir la résistance électrique voulue pour la conduction électrique, ce qui conduit à une section et des surfaces de contact de faibles dimensions autorisant une minimisation de la conduction thermique entre les dissipateurs 101 et 201, sachant que la conduction thermique et électrique entre les dissipateurs 101 et 201 ne peut se faire qu'à travers le bus barre 104 du fait de la présence de l'isolant thermique (et électrique) 105. La résistance thermique entre les dissipateurs 101 et 201 est ainsi augmentée ce qui réduit les échanges thermiques et autorise un bon découplage thermique entre le boc de puissance 100 et le bloc de filtrage 200, les deux blocs 100 et 200 fonctionnant dans des plages de température différentes. On notera que du fait de la présence de condensateurs 202, le bloc de filtrage 200 ne doit pas atteindre des températures trop élevées (dans un exemple non limitatif, de plus de 150°C) sinon, les condensateurs 202 pourraient subir des dégradations. Or le bloc de puissance 100 quant à lui peut dépasser les 150°C en raison de la présence des interrupteurs MOSFET qui libèrent beaucoup de chaleur. Il est ainsi nécessaire d'effectuer un découplage thermique entre le bloc de filtrage 200 et le bloc de puissance 100 tout en permettant le passage de courant entre les deux blocs.

Les isolants électriques 106 et 106' permettent l'isolation électrique entre les dissipateurs 101 et 201 au B- et le palier arrière au M- de la machine électrique tournante 10, sachant que la vis de montage 204 se visse dans la masse métallique du palier arrière de la machine. Les isolants électriques 106 et 106' empêchent tout contact entre la vis de montage 204 et les dissipateurs 101, 201 et bus barre 104.

Dans un exemple non limitatif, l'isolant 105 est une rondelle formée dans un plastique de faible conductivité thermique et les isolants 106 et 106' sont des rondelles formées dans un plastique de faible conductivité électrique. Ces rondelles sont illustrées sur la figure 5.

On notera que les orifices 1014, 2014 des pattes de montage devront avoir un diamètre suffisamment grand par rapport à celui de la vis de montage 204 pour éviter tout contact de celle-ci avec les parois internes des orifices 1014, 2014 et permettre l'insertion dans l'espace entre les bords circulaires / parois internes des orifices 1014, 2014 et la surface de tige de la vis de montage 204 d'un collerette de rebord (non représentée) des rondelles isolantes 106, 106', cette collerette de rebord garantissant l'impossibilité d'un tel contact. Ces moyens permettent d'obtenir le montage d'isolation électrique souhaité entre les masses métalliques des dissipateurs 101/201 et le palier arrière de la machine.

Un second point de montage (non illustré), au niveau de la borne électrique isolée 205, est utilisé pour l'assemblage électrique, thermique et mécanique de la combinaison 500, entre les blocs 100 et 200, et le montage de celle-ci au palier arrière de la machine. Les moyens utilisés étant sensiblement les mêmes que ceux utilisés au premier point de montage PM1, ceux-ci ne seront pas détaillés ici.

Bloc de contrôle

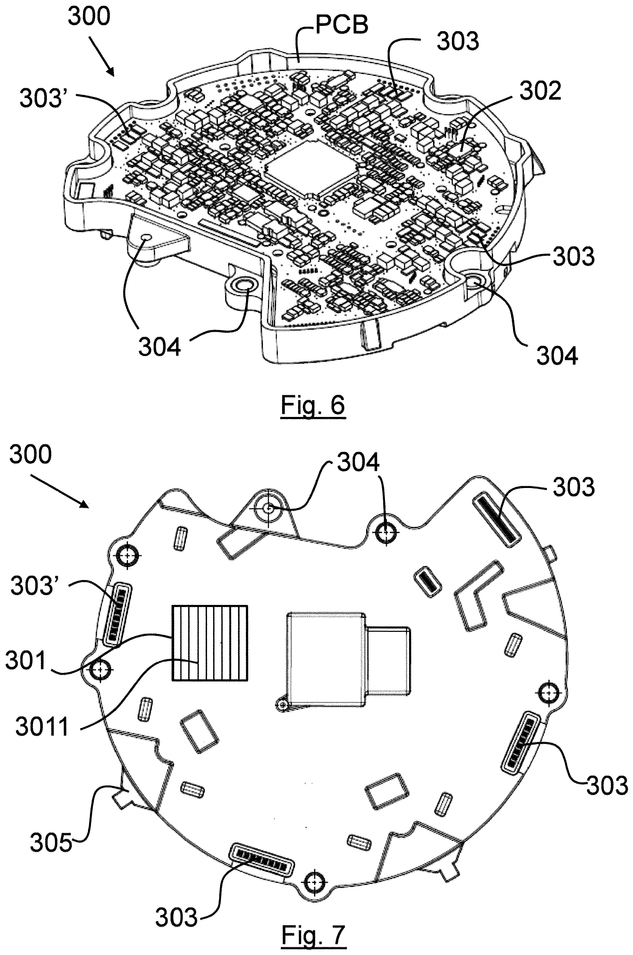

Le bloc de contrôle est illustré sur les figures 6 et 7.

Comme illustré sur la vue en perspective, le bloc de contrôle 300 comporte des composants 302 pour contrôler la machine électrique tournante et notamment le réglage de la machine en contrôlant les modules de puissance 1001 du bloc de puissance 100. Les composants 302 étant connus de l'homme du métier, ils ne sont pas décrits dans la suite de la description.

Le bloc de contrôle est composé d'une carte à circuit imprimée PCB (appelé en anglais « Printed Circuit Board ») sur laquelle sont montés les composants de contrôle 302.

Le bloc de contrôle 300 est séparé thermiquement du bloc de puissance 100. Ainsi, la fonction contrôle des modules de puissance n'est pas située dans ces derniers. A cet effet, selon l'invention, le bloc de contrôle 300 est disposé sur un premier plan parallèle à un deuxième plan sur lequel est monté le bloc de puissance 100 de sorte à permettre un passage d'un flux d'air de refroidissement F2 entre les deux blocs 100, 300. Ainsi, en créant un espace entre les deux blocs 100 et 300, cela permet d'amener de l'air entre les deux blocs. Le tout est ainsi refroidi tout en créant un découplage thermique entre les deux blocs. La création de ce flux d'air sera expliquée dans la suite de la description.

Dans un exemple non limitatif, le bloc de contrôle 300 est monté en mezzanine du bloc de puissance 100 au moyen d'orifices de montage 304 couplés aux plots de montage (non référencés) du premier dissipateur 101 qui servent d'entretoises comme vu précédemment.

Afin de communiquer entre eux, le bloc de puissance 100 et le bloc de contrôle 300 sont reliés entre eux au moyen de pins d'interconnexion. Ces pins d'interconnexion s'insèrent respectivement dans des emplacements prévus du bloc de contrôle. Chaque pin ayant une section faible, on minimise la possibilité d'échange thermique entre les deux blocs.

On notera que les modules de puissance 1001 comportent un premier ensemble de pins d'interconnexion, qui sont des pins de signal.

Par ailleurs, le module d'excitation 1002 comporte des pins d'interconnexion qui permettent d'envoyer des signaux de mesure et des signaux de commande. Ainsi, ils permettent de commander le courant d'excitation rotorique et de le contrôler, d'envoyer des signaux capteurs pour contrôler la position du rotor, de remonter la température de la machine etc.

On notera par ailleurs que lors de leur fonctionnement, certains composants du PCB s'échauffent et font monter la température de la plaque PCB. Aussi, afin de refroidir cette plaque PCB, dans un mode de réalisation non limitatif, le dispositif de refroidissement 10' comprend un troisième élément de refroidissement qui est un troisième dissipateur 301 illustré à la figure 6 (appelé également dissipateur de bloc de contrôle) muni d'une pluralité d'ailettes 3011 couplé au bloc de contrôle 300.

Ainsi, en implantant un dissipateur dans le boîtier PCB, et plus précisément sur la face inférieure du PCB, il est possible d'utiliser également le même flux d'air de refroidissement F2 qui permet le découplage thermique entre le bloc de contrôle 300 et le bloc de puissance 100, pour extraire les calories apportées par les composants du PCB.

Dans des exemples non limitatifs, le troisième dissipateur 301 est couplé à des composants du bloc de contrôle 300 au moyen d'une résine, d'une lame métallique, d'un joint de remplissage (appelé en anglais « gap filaire » ou d'un tampon de remplissage (appelé en anglais « gap pad »).

Capot de protection

Comme on va le voir ci-après, les flux d'air de refroidissement adaptés à chaque bloc de dissipation thermique différent sont générés et orientés sur les différents blocs au moyen du capot de protection et de la semelle 1016 du premier dissipateur 101. Une partie de ces flux d'air va donc lécher les ailettes des différents dissipateurs couplés aux différents blocs et ainsi optimiser le refroidissement desdits blocs, lesdites ailettes augmentant la surface de dissipation des composants qui chauffent.

Le capot de protection 400 est illustré sur la figure 8.

Comme illustré, le capot de protection 400 comporte des ouvertures qui sont réparties en :

- un premier ensemble d'ouvertures 401 adaptées pour être positionnées en regard des ailettes du premier dissipateur 101 et également en regard du bloc de contrôle 300 ; et
- un deuxième ensemble d'ouvertures 403 adapté pour être positionné en regard des ailettes du deuxième dissipateur 201 de sorte à créer un troisième flux d'air de refroidissement F3 pour ledit bloc de filtrage 200.

Le ventilateur de la machine électrique aspire de l'air pour refroidir la machine. Cet air est aspiré latéralement via les ouvertures 401, 403 du capot de protection et s'écoule ainsi vers et à travers lesdites ouvertures. A partir de cet air aspiré, du fait de la présence des deux types d'ouvertures 401 et 403, des flux d'air différents sont respectivement créés (F1 et F2 pour le premier ensemble d'ouvertures 401, et F3 pour le deuxième ensemble d'ouvertures 403).

• Premier ensemble d'ouvertures 401

Le premier ensemble d'ouvertures 401 couplé au premier dissipateur 101 permet le passage d'un premier flux d'air F1 et d'un deuxième flux d'air F2.

Le premier flux d'air F1 est aspiré par le ventilateur vers le bas. Il se retrouve à lécher la surface inférieure du bloc de puissance 100 (via le premier dissipateur 101). Comme on peut le voir sur les schémas explicatifs des figures 9a et 9b, le premier flux d'air F1 va s'écouler radialement à travers le premier ensemble d'ouvertures 401 et lécher les éléments dissipateurs, à savoir les ailettes 1011 du premier dissipateur 101 sur toute la longueur, avant de s'évacuer axialement vers la machine électrique 1, à savoir le long de l'axe AZ du rotor. Ainsi, le bloc de puissance 100 est refroidi à travers le refroidissement du premier dissipateur 101 via les ailettes.

Le deuxième flux d'air F2 s'écoule à travers également le premier ensemble d'ouvertures 401 et radialement sous la surface inférieure du bloc de contrôle 300, avant de s'évacuer axialement le long de l'axe AZ. Le bloc de contrôle 300 est ainsi refroidi.

La prolongation j de la semelle 1016 qui fait saillie par rapport au bloc de puissance 100 permet que les deux flux d'air F1 et F2 ne se mélangent pas.

Dans un premier mode de réalisation non limitatif illustré à la figure 9a, les ailettes 1011 du premier dissipateur 101 se situent sous le bloc de puissance 100 et ne font pas saillie par rapport audit bloc 100. Il n'y a pas d'ailettes 1011 le long du prolongement j.

Dans un deuxième mode de réalisation non limitatif illustré à la figure 9b, les ailettes 1011 du premier dissipateur 101 font saillie par rapport audit bloc 100. Elles sont donc réparties sous le bloc de puissance 100 mais également le long de la prolongation j du dissipateur 101.

On notera que la prolongation j de la semelle 1016 est à adapter suivant l'agencement capot / dissipateur de l'assemblage et suivant le point de fonctionnement que l'on souhaite favoriser. Plus la vitesse de rotation augmente et moins la prolongation j a de l'importance.

La prolongation j a donc un intérêt pour les faibles vitesses de rotation, où la perte de charge imposée par le ventilateur est faible et donc où la réduction de section de passage au niveau des ailettes (pertes de charge locale) a son importance.

Un bon découplage thermique entre les deux blocs 100 et 300 est obtenu par cette séparation du flux d'air de refroidissement en un premier flux F1 et un deuxième flux F2 ayant des chemins d'écoulement différents.

On notera que dans le mode de réalisation non limitatif où le troisième dissipateur 301 est présent, le refroidissement des composants du bloc de contrôle 300 par le flux d'air F2 est optimisé car ledit flux F2 va lécher les ailettes dudit troisième dissipateur. L'extraction des calories apportées par certains des composants du boîtier PCB qui s'échauffent est ainsi améliorée.

Selon l'invention, les ouvertures du premier ensemble d'ouvertures 401 du capot de protection 400 sont latérales et, selon un mode de réalisation non limitatif, disposées dans la même direction que les ailettes du premier dissipateur 101. Ainsi, les ouvertures du capot de protection étant disposées dans le même sens que les ailettes du premier dissipateur 101, à savoir ici à la verticale, le flux d'air qui passe par les ouvertures et qui vient lécher les ailettes est plus important que si les ouvertures étaient dans une direction différente.

Ainsi, le prolongement j de la semelle 1016 du premier dissipateur 101 par rapport au bloc de puissance 100 permet d'obtenir deux flux d'air pour refroidir respectivement le bloc de puissance 100 et le bloc de contrôle 300. Un unique ensemble d'ouvertures 401 sur la hauteur du capot de protection 400 (sur le côté) est nécessaire. Le prolongement de la semelle du dissipateur de puissance 101 permet ainsi de séparer les débits d'air dédiés au dissipateur de puissance (ailettes) et au découplage thermique entre l'électronique de puissance 100 et l'électronique de contrôle 300.

Pour optimiser le couplage ouvertures capot/ailettes du premier dissipateur 101, il faut que ces ouvertures soient correctement positionnées vis-à-vis des ailettes du premier dissipateur 101.

En référence plus particulièrement aux figures 9a, 9b et 10, l'arrangement des ailettes du premier dissipateur 101, du capot de protection 400 et des ouvertures du premier ensemble d'ouvertures 401 est effectué de manière à satisfaire les relations suivantes :

$$h \geq 0,5 \cdot ha \qquad\qquad (1)$$

$$H < 0,5 \cdot ha \quad , \text{ et} \qquad\qquad (2)$$

$$D \geq 0{,}5 \ . \ (d^2 - ((o\text{-}e)/2)^2)^{1/2} \ . \qquad\qquad (3)$$

Sachant que h est la hauteur de l'ouverture capot, ha est la hauteur de l'ailette, H est la distance entre le bas du capot et le bas de l'ouverture, D est la distance entre le bord intérieur du capot et le bord d'attaque de l'ailette, d est un espace inter-ailettes séparant deux ailettes adjacentes, o est la largeur d'une ouverture capot et e est l'épaisseur d'une ailette.

Les relations (1) à (3) ci-dessus ont été déterminées par la demanderesse au moyen d'essais et autorisent un bon refroidissement en termes d'obtention du meilleur compromis possible.

• Deuxième ensemble d'ouvertures 403

Dans un mode de réalisation non limitatif, le capot de protection 400 comporte en outre un deuxième ensemble d'ouvertures 403, tel qu'illustré sur la figure 8, qui va permettre de générer le troisième flux d'air F3. Ce dernier va s'écouler radialement à travers le deuxième ensemble d'ouvertures 403 et lécher les éléments dissipateurs, à savoir les ailettes du deuxième dissipateur 201 sur toute la longueur, avant de s'évacuer axialement vers la machine électrique, à savoir le long de l'axe AZ du rotor.

Dans un mode de réalisation non limitatif, les ouvertures du deuxième ensemble d'ouvertures 403 sont latérales et sont disposées dans la même direction que les ailettes du deuxième dissipateur 201.

Ainsi, ces ouvertures du capot de protection étant disposées dans le même sens que les ailettes du deuxième dissipateur 201, à savoir ici à la verticale, le flux d'air qui passe par les ouvertures et qui vient lécher les ailettes est plus important que si les ouvertures étaient dans une direction différente. Cela permet donc d'obtenir un bon refroidissement du bloc de filtrage 200 et par voie de conséquence des condensateurs 202.

• Troisième ensemble d'ouvertures 404

Dans un mode de réalisation non limitatif, le capot de protection 400 comporte en outre un troisième ensemble d'ouvertures 404 situées sur le dessus dudit capot 400 (tel qu'illustré sur la figure 8) adapté pour être positionné au dessus des condensateurs 202 du bloc de filtrage 200 de sorte à créer un quatrième flux d'air de refroidissement F4 pour le bloc de filtrage 200.

Tel qu'illustré, ce quatrième flux F4 va s'écouler axialement à travers le troisième ensemble d'ouvertures 404, à savoir parallèlement à l'axe AZ du rotor, et lécher les condensateurs 202, mais également les parois verticales 2012, avant de s'évacuer vers la machine électrique.

On créé ainsi un flux d'air axial refroidissant également les condensateurs de filtrage 202.

Ainsi, le bloc de filtrage 201 reçoit un flux d'air radial F3 et un flux d'air axial F4, ce qui permet d'obtenir un refroidissement optimal (composé de deux flux d'air) sur les ailettes. Grâce à cette optimisation d'échange thermique, les condensateurs sont ainsi bien refroidis.

On notera qu'une autre fonction du capot de protection 400 est de protéger l'ensemble électronique contre les agressions mécaniques telles que l'intrusion d'une vis ou d'un outil mécanique par exemple etc. Aussi, les ouvertures 401, 403 et également 404 doivent être dimensionnées pour éviter de telles agressions mécaniques et respecter une largeur maximale déterminée en fonction de la protection souhaitée contre lesdites agressions. La valeur de cette largeur est ainsi dictée par le degré de protection souhaitée pour l'alterno-démarreur contre la pénétration de corps étrangers, notamment solides (couramment appelé protection IP).

Ainsi, l'ensemble électronique 10 décrit précédemment permet de faire fonctionner l'alterno-démarreur. Ce dernier comporte :

- un rotor ;
- un stator couplé audit rotor et comportant une pluralité de phases ;
- un ensemble électronique 10 selon l'une quelconque des caractéristiques précédentes, le bloc de puissance 100 dudit ensemble électronique 10 étant adapté pour être connecté aux phases dudit stator ;
- un palier arrière supportant ledit stator ; et
- un ventilateur situé à proximité du palier arrière.

Bien entendu la description de l'invention n'est pas limitée à l'application, aux modes de réalisation et aux exemples décrits ci-dessus.

Ainsi, la présente invention s'applique à tout type de machines électriques tournantes polyphasées réversibles, tels que des alterno-démarreurs, entraînées par exemple par courroie ou intégrée, et notamment pour des applications hybrides.

Ainsi, dans un autre exemple d'application non limitatif, l'alterno-démarreur est « full-hybrid » et permet d'entraîner le véhicule automobile au moyen du moteur électrique seul (en général au démarrage), ou du moteur thermique seul (en général lorsque la vitesse augmente), ou des deux moteurs en même temps (par exemple pour obtenir une plus forte accélération). La batterie qui alimente le moteur électrique récupère de l'énergie par freinage récupératif.

Ainsi, l'invention décrite présente notamment les avantages suivants :

Elle permet un découplage thermique entre le bloc de contrôle et le bloc de puissance grâce à :

- leur assemblage mécanique : les deux blocs sont disposés sur deux plans parallèles avec un espace laissant passer un flux d'air, et
- leur assemblage électrique : les deux blocs sont connectés via les pins d'interconnexion qui minimisent la possibilité d'échange thermique entre les deux blocs, la surface d'échange thermique étant très réduite ;
- au deuxième flux d'air passant entre le bloc de contrôle et le bloc de puissance.

Elle permet un découplage thermique entre le bloc de puissance et le bloc de filtrage grâce à :

- l'isolement thermique du deuxième dissipateur et du premier dissipateur via les rondelles isolantes ;
- leur assemblage électrique : les deux blocs sont connectés via un unique bus barre qui minimise la possibilité d'échange thermique entre les deux blocs, la masse conductrice étant réduite.

Elle permet une optimisation du refroidissement des composants de l'ensemble électrique grâce :

- à l'architecture en blocs fonctionnels séparés, bloc de puissance, bloc de filtrage, bloc de contrôle, les blocs ayant des températures de fonctionnement différents (moyennes et maximales) ainsi que des besoins de dissipation différents ;
- à la création de flux d'air dédiés à chaque bloc fonctionnel via l'architecture particulière de la semelle du premier dissipateur (le prolongement j) et l'architecture du capot de protection du dispositif de refroidissement (les ouvertures pour orienter l'entrée d'air dans l'ensemble électronique en regard du bloc de puissance et du bloc de contrôle, la forme et le positionnement de ces ouvertures par rapport aux ailettes de refroidissement des premier et deuxième dissipateurs) ;
- au couplage des éléments de refroidissement du dispositif de refroidissement, à savoir des différents dissipateurs, avec les différents blocs fonctionnels, les ailettes desdits dissipateurs permettant d'augmenter la surface d'échange avec l'air pour évacuer les calories ;
- au passage d'un flux d'air radial et d'un flux d'air axial pour éviter une surchauffe des condensateurs et ainsi éviter qu'ils ne s'abîment ;
- à la résine qui permet une bonne évacuation des calories des condensateurs vers le deuxième dissipateur.

De plus, l'invention permet une simplification de la fabrication du capot de protection en ne réalisant qu'un seul ensemble d'ouvertures radiales sur le côté dudit capot.

**Revendications**

1. Machine électrique tournante (1) pour véhicule automobile comprenant

   - un rotor,
   - un stator couplé audit rotor et comportant une pluralité de phases,
   - un palier arrière supportant ledit stator,
   - un ventilateur situé à proximité du palier arrière, ledit ventilateur aspirant de l'air pour refroidir ladite machine (1), et
   - un ensemble électronique (10), ledit ensemble électronique (10) comportant :

     - des blocs (100, 300) de composants électroniques, les blocs (100, 300) ayant des besoins de dissipation thermique différents, les blocs (100, 300) comprenant un bloc de puissance (100) et un bloc de contrôle (300), le bloc de puissance (100) dudit ensemble électronique (10) étant adapté pour être connecté aux phases dudit stator ;
     - un dispositif de refroidissement (10') desdits blocs (100, 300), ledit dispositif de refroidissement (10')

comportant un capot de protection (400) adapté pour recouvrir les blocs de puissance et de contrôle (100, 300), ledit capot de protection (400) comportant un premier ensemble d'ouvertures (401) adaptées pour être positionnées en regard d'un premier élément de refroidissement couplé au bloc de puissance (100) pour le refroidir;

le premier élément de refroidissement étant un premier dissipateur (101) muni d'une semelle (1016) et d'une pluralité d'ailettes (1011), les ouvertures du premier ensemble d'ouvertures (401) du capot de protection (400) sont disposées en correspondance avec le premier dissipateur (101) et sont adaptées pour être positionnées en regard des ailettes (1011) du premier dissipateur (101) ;

ladite machine électrique tournante étant **caractérisée en ce que** ledit premier ensemble d'ouvertures (401) est adapté pour être positionné en regard du bloc de contrôle (300) ;
**en ce que** les ouvertures du premier ensemble d'ouvertures (401) du capot de protection (400) sont latérales ;
**en ce que** ladite semelle (1016) fait saillie par rapport au bloc de puissance (100) de sorte à produire un premier flux d'air de refroidissement radial (F1) par rapport à l'axe du rotor de ladite machine électrique tournante (1) pour ledit bloc de puissance (100) et un deuxième flux d'air de refroidissement radial (F2) par rapport à l'axe du rotor de ladite machine électrique tournante (1) pour ledit bloc de contrôle (300) ;
**en ce que** ledit air est aspiré latéralement via ledit premier ensemble d'ouvertures (401) du capot de protection (400) et s'écoule ainsi vers et à travers ledit premier ensemble d'ouvertures (401), ledit premier flux d'air de refroidissement radial (F1) et ledit deuxième flux d'air de refroidissement radial (F2) étant créés à partir de cet air aspiré,
et **en ce que** le bloc de contrôle (300) est disposé sur un premier plan parallèle à un deuxième plan sur lequel est monté ledit bloc de puissance (100) de sorte à permettre un passage dudit deuxième flux d'air de refroidissement radial (F2) entre le bloc de contrôle (300) et le bloc de puissance (100).

2. Machine électrique tournante (1) selon la revendication 1 dans laquelle l'ensemble électronique comprend un bloc de filtrage (200), ledit capot étant adapté pour recouvrir le bloc de filtrage (200).

3. Machine électrique tournante (1) selon la revendication 2, dans lequel le dispositif de refroidissement (10') comporte en outre un deuxième élément de refroidissement qui est un deuxième dissipateur (201) couplé à des condensateurs (202) dudit bloc de filtrage (200).

4. Machine électrique tournante (1) selon la revendication 3, dans lequel le capot de protection (400) comporte en outre un deuxième ensemble d'ouvertures (403) adaptées pour être positionnées en regard du deuxième dissipateur (201) de sorte à produire un troisième flux d'air de refroidissement radial (F3) pour ledit bloc de filtrage (200).

5. Machine électrique tournante (1) selon l'une quelconque des revendications 2 à 4, dans lequel le bloc de puissance (100) et le bloc de filtrage (200) sont reliés électriquement au moyen d'une pièce conductrice (104).

6. Machine électrique tournante (1) selon l'une quelconque des revendications 3 à 5, dans lequel le premier dissipateur (101) et le deuxième dissipateur (201) comportent respectivement des orifices de montage (1014-2014) adaptés pour coopérer entre eux.

7. Machine électrique tournante (1) selon les revendications 5 et 6, dans lequel l'assemblage entre le bloc de puissance (100) et le bloc de filtrage (200) fait appel à une vis de montage (204), ladite pièce conductrice (104), un isolant thermique (105) disposé entre une patte de montage (1014) du premier dissipateur (101) et une face inférieure de ladite pièce conductrice (104), un premier isolant électrique (106) disposé entre ladite pièce conductrice (104) et le palier arrière (40) de la machine électrique tournante, et un second isolant électrique (106') disposé entre une tête de la vis de montage (204) et une face supérieure d'une patte de montage (2014) du deuxième dissipateur (201).

8. Machine électrique tournante (1) selon l'une quelconque des revendications 2 à 7, dans lequel le capot de protection (400) comporte en outre un troisième ensemble d'ouvertures (404) situées sur le dessus dudit capot (400) adapté pour être positionné au dessus de condensateurs (202) du bloc de filtrage (200) de sorte à créer un quatrième flux d'air de refroidissement axial (F4) pour le bloc de filtrage (200).

9. Machine électrique tournante (1) selon l'une quelconque des revendications précédentes, dans lequel le dispositif de refroidissement (10') comporte en outre un troisième élément de refroidissement qui est un troisième dissipateur (301) couplé au bloc de contrôle (300).

**10.** Machine électrique tournante (1) selon la revendication précédente, dans lequel le troisième dissipateur (301) est couplé à des composants du bloc de contrôle (300) au moyen d'une résine, d'une lame métallique, d'un joint de remplissage ou d'un tampon de remplissage.

**11.** Machine électrique tournante (1) selon l'une des revendications précédentes prise ensemble avec les revendications 3 et 9, dans lequel le deuxième dissipateurs (201) et le troisième dissipateur (301) sont munis d'une pluralité d'ailettes (2011, 3011).

**12.** Machine électrique tournante (1) selon la revendication précédente, dans lequel les ailettes (1011) du premier dissipateur (101) sont disposées par groupes d'ailettes parallèles et les groupes sont disposés de manière à autoriser une circulation radiale d'un flux d'air de refroidissement sous le bloc de puissance (100).

**13.** Machine électrique tournante (1) selon la revendication 11 ou 12, dans lequel les ouvertures (403) du deuxième ensemble d'ouvertures sont adaptées pour être positionnées en regard des ailettes (2011) du deuxième élément de refroidissement (201).


**Patentansprüche**

**1.** Drehende elektrischen Maschine (1) für ein Kraftfahrzeug, umfassend

- einen Rotor,
- einen Stator, der an den Rotor gekoppelt ist und eine Mehrzahl von Phasen aufweist,
- ein hinteres Lager, das den Stator trägt,
- einen Ventilator, der sich in der Nähe des hinteren Lagers befindet, wobei der Ventilator Luft ansaugt, um die Maschine (1) zu kühlen, und
- eine elektronische Anordnung (10), wobei die elektronische Anordnung (10) Folgendes aufweist:
- Blöcke (100, 300) elektronischer Bauelemente, wobei die Blöcke (100, 300) unterschiedliche Wärmeableitungsbedarfe aufweisen, wobei die Blöcke (100, 300) einen Leistungsblock (100) und einen Steuerblock (300) umfassen, wobei der Leistungsblock (100) der elektronischen Anordnung (10) geeignet ist, an die Phasen des Stators angeschlossen zu sein;
- eine Vorrichtung zur Kühlung (10') der Blöcke (100, 300), wobei die Kühlvorrichtung (10') eine Schutzabdeckung (400) aufweist, die geeignet ist, die Leistungs- und Steuerblöcke (100, 300) abzudecken, wobei die Schutzabdeckung (400) eine erste Anordnung von Öffnungen (401) aufweist, die geeignet sind, gegenüber einem ersten Kühlelement positioniert zu sein, das an den Leistungsblock (100) gekoppelt ist, um ihn zu kühlen;
wobei das erste Kühlelement ein erster Ableiter (101) ist, der mit einer Grundplatte (1016) und einer Mehrzahl von Rippen (1011) versehen ist, wobei die Öffnungen der ersten Anordnung von Öffnungen (401) der Schutzabdeckung (400) in Entsprechung mit dem ersten Ableiter (101) angeordnet sind und geeignet sind, gegenüber den Rippen (1011) des ersten Ableiters (101) positioniert zu sein;
wobei die drehende elektrische Maschine **dadurch gekennzeichnet ist, dass** die erste Anordnung von Öffnungen (401) geeignet ist, gegenüber dem Steuerblock (300) positioniert zu sein;
dadurch, dass die Öffnungen der ersten Anordnung von Öffnungen (401) der Schutzabdeckung (400) seitlich sind; dadurch, dass die Grundplatte (1016) so im Verhältnis zum Leistungsblock (100) absteht, dass ein erster radialer Kühlluftstrom (F1) im Verhältnis zur Achse des Rotors der drehenden elektrischen Maschine (1) für den Leistungsblock (100) und ein zweiter radialer Kühlluftstrom (F2) im Verhältnis zur Achse des Rotors der drehenden elektrischen Maschine (1) für den Steuerblock (300) erzeugt wird;
dadurch, dass die Luft seitlich über die erste Anordnung von Öffnungen (401) der Schutzabdeckung (400) angesaugt wird und so in Richtung und durch die erste Anordnung von Öffnungen (401) strömt, wobei der erste radiale Kühlluftstrom (F1) und der zweite radiale Kühlluftstrom (F2) aus dieser angesaugten Luft erzeugt werden, und dadurch, dass der Steuerblock (300) auf einer ersten Ebene parallel zu einer zweiten Ebene angeordnet ist, auf der der Leistungsblock (100) angebracht ist, um einen Durchtritt des zweiten radialen Kühlluftstoms (F2) zwischen dem Steuerblock (300) und dem Leistungsblock (100) zu gestatten.

**2.** Drehende elektrische Maschine (1) nach Anspruch 1, wobei die elektronische Anordnung einen Filterungsblock (200) umfasst, wobei die Abdeckung geeignet ist, den Filterungsblock (200) abzudecken.

**3.** Drehende elektrische Maschine (1) nach Anspruch 2, wobei die Kühlvorrichtung (10') ferner ein zweites Kühlelement aufweist, das ein zweiter Ableiter (201) ist, der an Kondensatoren (202) des Filterungsblocks (200) gekoppelt ist.

**4.** Drehende elektrische Maschine (1) nach Anspruch 3, wobei die Schutzabdeckung (400) ferner eine zweite Anordnung von Öffnungen (403) aufweist, die geeignet sind, gegenüber dem zweiten Ableiter (201) so positioniert zu sein, dass ein dritter radialer Kühlluftstrom (F3) für den Filterungsblock (200) erzeugt wird.

**5.** Drehende elektrische Maschine (1) nach einem der Ansprüche 2 bis 4, wobei der Leistungsblock (100) und der Filterungsblock (200) mittels eines leitendes Teils (104) elektrisch verbunden sind.

**6.** Drehende elektrische Maschine (1) nach einem der Ansprüche 3 bis 5, wobei der erste Ableiter (101) und der zweite Ableiter (201) jeweils Montageöffnungen (1014-2014) aufweisen, die geeignet sind, miteinander zusammenzuwirken.

**7.** Drehende elektrische Maschine (1) nach Anspruch 5 oder 6, wobei der Zusammenbau zwischen dem Leistungsblock (100) und dem Filterungsblock (200) eine Montageschraube (204), das leitende Teil (104), einen Wärmeisolator (105), der zwischen einem Montagefuß (1014) des ersten Ableiters (101) und einer Unterseite des leitenden Teils (104) angeordnet ist, einen ersten elektrischen Isolator (106), der zwischen dem leitenden Teil (104) und dem hinteren Lager (40) der drehenden elektrischen Maschine angeordnet ist, und einen zweiten elektrischen Isolator (106'), der zwischen einem Kopf der Montageschraube (204) und einer Oberseite eines Montagefußes (2014) des zweiten Ableiters (201) angeordnet ist, erfordert.

**8.** Drehende elektrische Maschine (1) nach einem der Ansprüche 2 bis 7, wobei die Schutzabdeckung (400) ferner eine dritte Anordnung von Öffnungen (404) aufweist, die sich auf der Oberseite der Abdeckung (400) befinden, die geeignet ist, über Kondensatoren (202) des Filterungsblocks (200) so positioniert zu sein, dass ein vierter axialer Kühlluftstrom (F4) für den Filterungsblock (200) erzeugt wird.

**9.** Drehende elektrische Maschine (1) nach einem der vorhergehenden Ansprüche, wobei die Kühlvorrichtung (10') ferner ein drittes Kühlelement aufweist, das ein dritter Ableiter (301) ist, der an den Steuerblock (300) gekoppelt ist.

**10.** Elektronische Anordnung (1) nach dem vorhergehenden Anspruch, wobei der dritte Ableiter (301) mittels eines Harzes, eines Metallblatts, eines Gap-Fillers oder eines Gap-Pads an Bauelemente des Steuerblocks (300) gekoppelt ist.

**11.** Drehende elektrische Maschine (1) nach einem der vorhergehenden Ansprüche zusammengenommen mit den Ansprüchen 3 und 9, wobei der zweite Ableiter (201) und der dritte Ableiter (301) mit einer Mehrzahl von Rippen (2011, 3011) versehen sind.

**12.** Drehende elektrische Maschine (1) nach dem vorhergehenden Anspruch, wobei die Rippen (1011) des ersten Ableiters (101) in Gruppen paralleler Rippen angeordnet sind und die Gruppen so angeordnet sind, dass eine radiale Durchströmung eines Kühlluftstroms unter dem Leistungsblock (100) ermöglicht wird.

**13.** Drehende elektrische Maschine (1) nach Anspruch 11 oder 12, wobei die Öffnungen (403) der zweiten Anordnung von Öffnungen geeignet sind, gegenüber den Rippen (2011) des zweiten Kühlelements (201) positioniert zu sein.

**Claims**

**1.** Rotating electric machine (1) for a motor vehicle comprising

- a rotor,
- a stator coupled to said rotor and comprising a plurality of phases,
- a rear bearing supporting said stator,
- a fan situated close to the rear bearing, said fan drawing in air to cool said machine (1), and
- an electronic assembly (10), said electronic assembly (10) comprising:
- blocks (100, 300) of electronic components, the blocks (100, 300) having different heat dissipation needs, the blocks (100, 300) comprising a power block (100) and a control block (300), the power block (100) of said electronic assembly (10) being designed to be connected to the phases of said stator;
- a cooling device (10') for cooling said blocks (100, 300), said cooling device (10') comprising a protective cap (400) designed to cover the power and control blocks (100, 300), said protective cap (400) comprising a first set of apertures (401) that are designed to be positioned facing a first cooling element that is coupled to the power block (100) in order to cool the latter;

the first cooling element being a first heat sink (101) provided with a base (1016) and with a plurality of fins (1011), the apertures of the first set of apertures (401) of the protective cap (400) are disposed to match with the first heat sink (101) and are designed to be positioned facing the fins (1011) of the first heat sink (101) ;

said rotating electric machine being **characterized in that** said first set of apertures (401) is designed to be positioned facing the control block (300);
**in that** the apertures of the first set of apertures (401) of the protective cap (400) are lateral;
**in that** said base (1016) protrudes with respect to the power block (100) so as to produce a first cooling air stream (F1), radial with respect to the axis of the rotor of said rotating electric machine (1), for said power block (100) and a second cooling air stream (F2), radial with respect to the axis of the rotor of said rotating electric machine (1), for said control block (300);
**in that** said air is drawn in laterally via said first set of apertures (401) of the protective cap (400) and thus flows towards and through said first set of apertures (401), said radial first cooling air stream (F1) and said radial second cooling air stream (F2) being created from this drawn-in air,
and **in that** the control block (300) is disposed on a first plane that is parallel to a second plane on which said power block (100) is mounted so as to allow said radial second cooling air stream (F2) to pass between the control block (300) and the power block (100).

2.  Rotating electric machine (1) according to Claim 1, wherein the electronic assembly comprises a filtering block (200), said cap being designed to cover the filtering block (200).

3.  Rotating electric machine (1) according to Claim 2, wherein the cooling device (10') further comprises a second cooling element which is a second heat sink (201) coupled to capacitors (202) of said filtering block (200) .

4.  Rotating electric machine (1) according to Claim 3, wherein the protective cap (400) further comprises a second set of apertures (403) that are designed to be positioned facing the second heat sink (201) so as to produce a radial third cooling air stream (F3) for said filtering block (200).

5.  Rotating electric machine (1) according to any one of Claims 2 to 4, wherein the power block (100) and the filtering block (200) are linked electrically by means of a conductive piece (104).

6.  Rotating electric machine (1) according to any one of Claims 3 to 5, wherein the first heat sink (101) and the second heat sink (201) respectively comprise mounting orifices (1014-2014) designed to cooperate with one another.

7.  Rotating electric machine (1) according to Claims 5 and 6, wherein the join between the power block (100) and the filtering block (200) involves a mounting screw (204), said conductive piece (104), a thermal insulator (105) disposed between a mounting lug (1014) of the first heat sink (101) and a lower face of said conductive piece (104), a first electrical insulator (106) disposed between said conductive piece (104) and the rear bearing (40) of the rotating electric machine, and a second electrical insulator (106') disposed between a head of the mounting screw (204) and a top face of a mounting lug (2014) of the second heat sink (201).

8.  Rotating electric machine (1) according to any one of Claims 2 to 7, wherein the protective cap (400) further comprises a third set of apertures (404) situated on the top of said cap (400) designed to be positioned above capacitors (202) of the filtering block (200) so as to create an axial fourth cooling air stream (F4) for the filtering block (200).

9.  Rotating electric machine (1) according to any one of the preceding claims, wherein the cooling device (10') further comprises a third cooling element which is a third heat sink (301) coupled to the control block (300).

10. Rotating electric machine (1) according to the preceding claim, wherein the third heat sink (301) is coupled to components of the control block (300) by means of a resin, a metal blade, a gap filler or a gap pad.

11. Rotating electric machine (1) according to one of the preceding claims taken together with Claims 3 and 9, wherein the second heat sink (201) and the third heat sink (301) are provided with a plurality of fins (2011, 3011) .

12. Rotating electric machine (1) according to the preceding claim, wherein the fins (1011) of the first heat sink (101) are disposed in groups of parallel fins and the groups are disposed so as to allow radial circulation of a cooling air stream under the power block (100) .

13. Rotating electric machine (1) according to Claim 11 or 12, wherein the apertures (403) of the second set of apertures are designed to be positioned facing the fins (2011) of the second cooling element (201).

Fig. 1

Fig. 2a

Fig. 2b

Fig. 3a

Fig. 3b

Fig. 4

Fig. 5

Fig. 6

Fig. 7

Fig. 8

Fig. 9a

Fig. 9b

A-A

400

1011

d

d

e

D

o

401

A    A

400

Fig. 10

**EP 2 913 910 B1**

## RÉFÉRENCES CITÉES DANS LA DESCRIPTION

### Documents brevets cités dans la description

- WO 2009063774 A
- FR 2847085
- FR 1358616